# EUROPEAN PATENT APPLICATION

(11) **EP 1 813 658 A2**
(43) Date of publication of application: **01.08.2007**
(21) Application number: 07002007.8
(22) Date of filing: 30.01.2007
(51) Int. Cl.: C09G 1/02, C09K 3/14

(54) **Polishing liquid for barrier layer**

(30) Priority: 31.01.2006 JP 2006023204
(71) Applicant: Fujifilm Corporation, Minato-ku Tokyo (JP)
(72) Inventor: Kamimura, Tetsuya, Haibara-gun Shizuoka-ken (JP); Takenouchi, Kenji, Ebina-shi Kanagawa (JP)
(74) Representative: HOFFMANN EITLE

(57) **Abstract**

According to an aspect of the invention, there is provided a polishing liquid for polishing a barrier layer of a semiconductor integrated circuit, the polishing liquid including colloidal silica covered at a portion of a surface thereof with aluminum, and an oxidizing agent, wherein the polishing liquid has a pH of from 2 to 7.

## Description

### BACKGROUND OF THE INVENTION

### Field of the Invention

The present invention relates to a polishing liquid which is used for producing a semiconductor device, and in particular to a polishing liquid which is favorably used for polishing barrier metal materials for flattening in a wiring process of a semiconductor device.

### Description of the Related Art

In the development of semiconductor devices such as semiconductor integrated circuits (referred to as LSIs hereinafter), higher density and higher integration by fine and laminated wiring lines have been required in recent years for miniaturization and high speed processing of the devices. One of various technologies used for this purpose is chemical mechanical polishing (referred to as CMP hereinafter). CMP is an essential technology for flattening the surface of a film to be processed such as an interlayer insulation film, for forming plugs and for forming embedded metal wiring, and is performed for smoothening a substrate, for removing excess metal thin films when forming wiring lines and for removing excess barrier layers on an insulation film.

In a usual method of CMP, a polishing pad is attached on a circular polishing platen, the surface of the polishing pad is impregnated with a polishing liquid, the surface of a substrate (wafer) is pressed onto the surface of the polishing pad, both the polishing platen and substrate are allowed to rotate while a predetermined pressure is applied at the back face of the substrate, and the surface of the substrate is flattened by a mechanical friction that is generated.

While fine wiring lines are formed in multilayer form for producing a semiconductor device such as an LSI, barrier metals such as Ta, TaN, Ti and TiN are formed in advance for preventing wiring materials from diffusing into the interlayer insulation films and for improving adhesiveness of the wiring materials when metal wiring lines such as Cu lines are formed in each layer.

In a conventional process for forming each wiring layer, CMP of metal films (referred to as metal film CMP hereinafter) for removing excess wiring materials heaped by plating is performed one or several times, and CMP for removing barrier metal materials (barrier metals) thus exposed on the surface (referred to as barrier metal CMP hereinafter) is subsequently performed. However, there are problems in that wiring portions are excessively polished by metal film CMP, which is called dishing, and further erosion is caused.

For reducing this dishing, in barrier metal CMP which is performed after metal film CMP, it is required to adjust the polishing speed of the metal wiring portions and the polishing speed of the barrier metal portions, to thereby ultimately form wiring layers having fewer concavities due to dishing and erosion. In other words, since the wiring portions are rapidly polished to cause dishing and erosion when the polishing speeds of the barrier metal and interlayer insulation film are smaller than the polishing speed of the metal wiring material in barrier metal CMP, it is desirable that the barrier metal and insulation film layer have an appropriately higher polishing speed. This is not only because there is an advantage of enhancing the throughput of barrier metal CMP, but also because substantially dishing is often caused by metal film CMP and thus it is required to relatively enhance the polishing speeds of the barrier metal and insulation layer as mentioned above.

A polishing liquid for metal that is used for CMP generally contains polishing particles (for example, alumina and silica) and an oxidizing agent (for example, hydrogen peroxide and persulfuric acid). It is considered that polishing is conducted by a basic mechanism of oxidizing the surface of a metal by an oxidizing agent and removing oxide films with the polishing particles.

However, when CMP is conducted by using such a polishing liquid containing solid polishing particles, polishing scratches, a phenomenon where the entire polishing surface is polished excessively (thinning), a phenomenon that the polishing metal surface is distorted in a dish-like shape (dishing), and a phenomenon that insulators between metal wirings are polished excessively and plural wiring metal surfaces are distorted in a dish-like shape (erosion) sometimes occur.

Further use of a polishing liquid containing solid polishing particles complicates the cleaning step usually conducted after polishing for removing a polishing liquid remaining on the surface of a semiconductor and, further, disposal of a liquid used for the cleaning (liquid wastes) involves a problem in cost due to requirement for precipitating the solid polishing particles for separation thereof.

Various studies of polishing liquids containing solid polishing particles have been made as follows.

A CMP polishing agent and a polishing method for high speed polishing with little generation of scratches (for example Japanese Patent Application Laid-Open (JP-A) No. 2003-17446), a polishing composition and polishing method for improving cleanablity in CMP (JP-A No. 2003-142435), and a polishing composition for preventing polishing particles from aggregating (JP-ANo. 2000-84832) have been proposed.

However, in the polishing liquid as described above, suppression of the erosion occurring upon polishing a barrier layer and suppression of scratches generated due to aggregation of the solid polishing particles have not yet been achieved at the same time.

### SUMMARY OF THE INVENTION

The present invention has been made in view of the above circumstances and provides a polishing liquid for a barrier layer.

According to an aspect of the invention, there is provided a polishing liquid for polishing a barrier layer of a semiconductor integrated circuit, the polishing liquid comprising colloidal silica covered at a portion of a surface thereof with aluminum, and an oxidizing agent, wherein the polishing liquid has a pH of from 2 to 7.

### DETAILED DESCRIPTION OF THE INVENTION

Specific embodiments of the invention are to be described below.

The polishing liquid for a barrier layer according to the invention is a polishing liquid for polishing a barrier layer of a semiconductor integrated circuit and contains a colloidal silica covered at a portion of the surface thereof with aluminum, and an oxidizing agent, and has a pH of 2 to 7.

In addition, the polishing liquid for a barrier layer according to the invention may further contain other components, and preferable examples of the components include, for example, quaternary alkyl ammonium compounds, anionic surfactants, organic acids, heteroaromatic ring compounds, etc. One or more of components as above may be used alone or in combination.

Hereinafter, the polishing liquid for a barrier layer according to the invention is sometimes referred to simply as a polishing liquid.

The term "polishing liquid" in the invention means a polishing liquid to be directly used for polishing (that is, a polishing liquid that has been diluted as necessary) or a concentrated liquid of the polishing liquid. The concentrated liquid or concentrated polishing liquid means a polishing liquid prepared to have a higher concentration than that of the polishing liquid to be directly used for polishing, and is used for polishing after diluting with water or with an aqueous solution. The dilution factor is usually in the range from 1 to 20 times by volume. The terms "concentrated" and "concentrated liquid" as used in this specification are used according to idiomatic expressions meaning that the liquid is "denser" and "a denser liquid" than the liquid to be directly used, and are used in a different meaning from conventional terms meaning a liquid that has been subjected to a physical concentration operation such as evaporation.

Each of the components contained in the polishing liquid of the invention is to be described, specifically.

### [Colloidal silica covered at a portion of the surface thereof with aluminum]

The polishing liquid of the invention contains, as at least a portion of the polishing particles, colloidal silica covered at a portion of a surface thereof with aluminum. It is hereinafter optionally referred to as a specific colloidal silica.

In the invention, "colloidal silica coated at a portion of the surface thereof with aluminum" means silica in a state where aluminum is present on the colloidal silica surface having sites containing silicon atoms with a coordination number of 4, and may be silica in a state where aluminum atoms to each of which four oxygen atoms are coordinated are bonded to the surface of the colloidal silica and a new surface where aluminum atoms are fixed in the state of 4-coordination is formed, or silica in a state where silicon atoms present on the surface of the colloidal silica are replaced with aluminum atoms to form a new surface.

The colloidal silica used for the preparation of the specific colloidal silica is preferably a colloidal silica obtained by hydrolysis of an alkoxy silane not containing impurities such as alkali metals in the inside of the particles. On the other hand, while a colloidal silica prepared by a method of removing an alkali from an aqueous solution of an alkali silicate can also be used, there may be a concern that the alkali metal remaining in the inside of the particle is gradually leached to give undesired effects on the polishing performance in this case. From a view point as described above, those obtained by hydrolysis of an alkoxy silane as described above are more preferable as the starting material.

The particle diameter of the colloidal silica as the starting material may be properly selected in accordance with the purpose of using the polishing particles and it is generally about from 10 to 200 nm.

For example, as a method for obtaining the specific colloidal silica, a method of adding an aluminate compound such as sodium aluminate to a dispersion liquid of a colloidal silica can be used suitably. Such a method is described in detail in Japanese Patent No. 3463328 and JP-A No. 63-123807, the disclosures of which are incorporated by reference herein.

Specifically, JP No. 3463328, the disclosure of which is incorporated by reference herein, discloses a production process of heating a silica sol obtained by adding an aqueous solution of an alkali aluminate at 80 to 250°C for 0.5 to 20 hours and bringing it into contact with a cation exchange resin, or a cation exchange resin and an anionic exchange resin.

Further, JP-A No. 63-123807, the disclosure of which is incorporated by reference herein, discloses a method of treating an aluminum compound-containing alkaline silica sol with a cation exchange resin for dealkylation, the alkaline silica sol being prepared by a method of adding an acidic silicic acid solution and an aqueous solution of an aluminum compound to an aqueous SiO₂-containing alkali solution or an aqueous alkali metal hydroxide solution, or by a method of adding an acidic silicic acid solution in which an aluminum compound is present to an SiO₂-containing aqueous alkali solution or an aqueous alkali metal hydroxide solution. These methods can be applied to the present invention.

Further, examples of other methods include a method of adding an aluminum alkoxide to a dispersion liquid of a colloidal silica.

Any aluminum alkoxide may be used herein and preferable examples include aluminum isopropoxide, aluminum butoxide, aluminum methoxide, and aluminum ethoxide, and particularly preferable example include aluminum isopropoxide and aluminum butoxide.

The specific colloidal silica obtained by a method as described above has aluminosilicate sites formed by the reaction between aluminate ions of 4-cordination and silanol groups on the surface of a colloidal silica, which fix negative charges and provide the particles with a high negative zeta potential. Thus, the specific colloidal silica has a feature of being excellent in dispersibility in an acidic condition.

Accordingly, it is important that, on the specific colloidal silica prepared by the method as described above, aluminum atoms are present to each of which four oxygen atoms are coordinated.

The aluminum atoms, to each of which four oxygen atoms are coordinated, and which are present on the surface of the specific colloidal silica in the invention, can be easily confirmed, for example, by measuring the zeta potential.

In the specific colloidal silica in the invention, the covering amount of aluminum is represented by a surface atom substitution ratio of a colloidal silica (number of introduced aluminum atoms/number of surface silicon atom sites). The surface atom substitution ratio is preferably 0.001% to 20%, more preferably 0.01% to 10%, and particularly preferably 0.1% to 5%.

The surface atom substitution ratio can be properly controlled by controlling the addition amount (concentration) of an aluminate compound and an aluminum alkoxide to be added to the dispersion liquid of the colloidal silica as the starting material.

The surface atom substitution ratio of the specific colloidal silica (number of introduced aluminum atoms/number of surface silicon atom sites) can be determined as described below.

At first, among the aluminum compounds added to the dispersion liquid, the amount of the aluminum compounds consumed is calculated from the amount of the unreacted aluminum compounds remaining after the reaction. Assuming that 100% of the consumed aluminum compounds have been reacted, the surface atom substitution ratio can be estimated from the surface area converted from the diameter of the colloidal silica, the specific gravity 2.2 of the colloidal silica, and the number of silanol groups per unit surface area (5 to 8/nm²). The actual measurement is carried out by conducting an elemental analysis of the obtained specific colloidal silica per se, assuming that aluminum is not present in the inside of the particle but uniformly and thinly covers the surface, and using the surface area/specific gravity of the specific colloidal silica and the number of silanol groups per unit surface area.

A specific preparation method of the specific colloidal silica in the invention is to be described below.

At first, the colloidal silica is dispersed in water within a range from 1 to 50 mass%, the pH of the dispersion liquid is adjusted to 7 to 11, and subsequently an aqueous solution of sodium aluminate is added thereto while stirring at around room temperature and the stirring is continued as it is for 0.5 to 10 hours.

By removing impurities from the thus obtained sol by ion exchange or ultrafiltration, the specific colloidal silica can be obtained.

The size (volume equivalent diameter) of the obtained specific colloidal silica is preferably 3 nm to 200 nm, more preferably from 5 nm to 100 nm, and particularly preferably from 10 nm to 60 nm.

As the particle diameter of the specific colloidal silica (volume equivalent diameter), a value measured by a dynamic light scattering method is adopted.

The content of the specific colloidal silica in the polishing liquid of the invention is, based on the mass of the polishing liquid to be directly used for polishing (that is, a polishing liquid after dilution in a case of dilution with water or aqueous solution, and "polishing liquid to be directly used for polishing" hereinafter also having the same meaning), preferably 1 mass% to 15 mass%, more preferably 3 mass% to 12 mass%, and particularly preferably 5 mass% to 12 mass%. That is, the content of the specific colloidal silica is preferably 1% or more from a view point of polishing the barrier layer at a sufficient polishing speed, and preferably 15 mass% or less from a view point of storage stability.

In the polishing particles contained in the polishing liquid of the invention, the ratio of the specific colloidal silica is preferably 50 mass% or more, and particularly preferably 80 mass% or more. All of the polishing particles contained may be the specific colloidal silica.

The polishing particles other than the specific silica in the polishing liquid of the invention are preferably fumed silica, colloidal silica, ceria, alumina and titania, and particularly preferably a colloidal silica. The size of them is preferably not less than but not more than twice the size of the specific colloidal silica.

### [Oxidizing agent]

The polishing liquid of the invention contains a compound capable of oxidizing the metal to be polished (an oxidizing agent).

Examples of the oxidizing agent include hydrogen peroxide, peroxides, nitrate salts, iodate salts, periodate salts, hypochlorite salts, chlorite salts, chlorate salts, perchlorate salts, persulfate salts, bichromate salts, permanganate salts, aqueous ozone, silver (II) salts and iron (III) salts, and hydrogen peroxide is preferably used.

Inorganic iron (III) salts such as iron (III) nitrate, iron (III) chloride, iron (III) sulfate and iron (III) bromide as well as organic complexes of iron (III) are preferably used as the iron (III) salts.

The addition amount of the oxidizing agent can be controlled according to the amount of dishing at the initial stage of barrier metal CMP. When the amount of dishing at the initial stage of barrier metal CMP is large, that is, when the wiring material is not desired to be polished so much during barrier metal CMP, the addition amount of the oxidizing agent is desirably small, while the addition amount of the oxidizing agent is desirably increased when the amount of dishing at the initial stage of barrier metal CMP is small and the wiring material is to be polished at a high speed. Since it is desirable to change the addition amount of the oxidizing agent depending on the dishing conditions at the initial stage of barrier metal CMP, the content of the oxidizing agent in 1 L of the polishing liquid to be directly used for polishing is preferably in the range from 0.01 to 1 mole, particularly preferably in the range from 0.05 to 0.6 moles.

### [Quaternary alkyl ammonium]

The polishing liquid of the invention preferably contains a quaternary alkyl ammonium compound.

Examples of the quaternary alkyl ammonium include, for example, tetramethyl ammonium hydroxide, tetramethyl ammonium nitrate, tetraethyl ammonium hydroxide, tetraethyl ammonium nitrate, and stearine trimethyl ammonium nitrate. Among them, tetramethyl ammonium hydroxide is particularly preferable.

The content of the quaternary alkyl ammonium is, based on the mass of the polishing liquid to be directly used for polishing, preferably 0.01 mass% to 20 mass%, more preferably 0.1 mass% to 5 mass%, and particularly preferably 0.5 mass% to 2 mass%. That is, the content of the quaternary alkyl ammonium compounds is preferably 0.01 mass% or more from a view point of sufficiently providing the erosion suppressing effect and preferably 20% or less from a view point of not greatly lowering the polishing speed.

### [Anionic surfactant]

The polishing liquid of the invention preferably contains an anionic surfactant.

Examples of the anionic surfactant include carboxylate salts, sulfonate salts, sulfate ester salts, and phosphate ester salts.

More specifically, preferable examples thereof include carboxylate salts such as soaps, N-acylamino acid salts, polyoxyethylene or polyoxypropylene alkyl ether carboxylate salts, and acylated peptides;
sulfonate salts such as alkyl sulfonate salts, alkyl benzene or alkyl naphthalene sulfonate salts, naphthalane sulfonate salts, sulfosuccinic acids salts, α-olefin sulfonate salts, and N-acylsulfonate salts;
sulfate ester salts such as sulfated oils, alkyl sulfate salts, alkyl ether sulfate salts, polyoxyethylene or polyoxypropylene alkyl allyl ether sulfate salts, alkyl amide sulfate salts; and
phosphate ester salts such as alkyl phosphates, polyoxyethylene or polyoxypropylene alkyl allyl ether phosphate salts.

The addition amount of the anionic surfactant, as a total amount, is preferably 0.001 to 10 g, more preferably 0.01 to 5 g, and particularly preferably 0.01 to 1 g, in 1 L of the polishing liquid to be directly used for polishing. That is, the addition amount of the anionic surfactant is preferably 0.01 g or more for obtaining sufficient effect, and preferably 1 g or less from a view point of preventing lowering of the CMP speed.

### [Organic acid]

The polishing liquid of the invention preferably contains an organic acid having at least one carboxylic group in the molecule. The organic acid is preferably a compound represented by the following formula (1):

Formula (1) R-COOH

wherein R represents a hydrogen atom, carboxyl group, or hydrocarbon group, and the hydrocarbon group may further be substituted with a hydroxyl group, carboxyl group, or hydrocarbon group.

In the formula (1), the hydrocarbon group represented by R may be saturated or unsaturated, and may have a chain, cyclic or branched structure. Examples of the hydrocarbon group include, specifically, an alkyl group, cycloalkyl group, aryl group, alkenyl group, etc.

The hydrocarbon group may have a substituent, and examples of the substituent that can be introduced include a hydroxyl group, carboxyl group, and hydrocarbon group.

Preferable examples of the organic acid include benzoic acid, glycolic acid, salicylic acid, oxalic acid, malonic acid, succinic acid, glutaric acid, adipic acid, pimelic acid, maleic acid, phthalic acid, malic acid, tartaric acid, citric acid, lactic acid, etc.

The addition amount of the organic acid having a carboxyl group is, based on the mass of the polishing liquid to be directly used for polishing, preferably 0.1 mass% to 5 mass%, and more preferably 0.5 mass% to 2 mass%. That is, the content of the organic acid is preferably 0.1 mass% or more for attaining a sufficient polishing speed, and preferably 5 mass% or less from a view point of not causing excessive dishing.

Two or more organic acids containing at least one carboxylic group in the molecule may be contained in the polishing liquid.

### [Heteroaromatic ring compound]

The polishing liquid of the invention preferably contains a heteroaromatic ring compound containing three or more nitrogen atoms in the molecule and having a condensed ring structure. "Three or more nitrogen atoms" referred to herein are preferably atoms included in the condensed ring, and the heteroaromatic ring compound is preferably benzotriazole and a derivative in which various substituents are introduced to the benzotriazole.

Preferable examples of the heteroaromatic ring compound include benzotriazole, 1,2,3-benzotriazole, 5,6-dimethyl-1,2,3-benzotriazole, 1-(1,2-dicarboxyethyl)benzotriazole, 1-[N,N-bis(hydroxyethyl)aminomethyl]benzotriazole, 1-(hydroxymethyl)benzotriazole, etc.

The addition amount of the heteroaromatic ring compound is, based on the mass of the polishing liquid to be directly used for polishing, preferably 0.01 mass% to 0.2 mass%, and more preferably 0.05 mass% to 0.2 mass%. That is, the addition amount of the heteroaromatic ring compound is preferably 0.01 mass% or more from a view point of not extending dishing, and preferably 0.2 mass% or less from a view point of storage stability.

### [pH control agent]

The polishing liquid of the invention has a pH in the range from 2.0 to 7.0, preferably in the range from 2.0 to 5.0. An alkali/acid or a buffer agent is used for controlling the pH in a desirable range. The polishing liquid of the invention exhibits excellent effects in the above-mentioned pH range.

Preferable examples of the alkali/acid or buffer agent include non-metallic alkali agents including ammonia, ammonium hydroxide, organic ammonium hydroxide such as tetramethyl ammonium hydroxide, and alkanol amines such as diethanol amine, triethanol amine and triisopropanolamine; alkali metal hydroxides such as sodium hydroxide, potassium hydroxide and lithium hydroxide; inorganic acids such as nitric acid, sulfuric acid and phosphoric acid; carbonate salts such as sodium carbonate; phosphoric salts such as trisodium phosphate; borate salts, tetraborate salts and hydroxybenzoate salts. Ammonium hydroxide, potassium hydroxide, lithium hydroxide and tetramethyl ammonium hydroxide are particularly preferable alkali agents.

The addition amount of the alkali/acid or buffer agent may be an amount such that the pH is maintained within the preferable range and the electric conductivity is below the afore-mentioned level. The amount is preferably in the range from 0.0001 to 1.0 mol, more preferably in the range from 0.003 to 0.5 mol, in 1 L of the polishing liquid to be directly used for polishing.

### [Chelating agent]

The polishing liquid of the invention preferably contains a chelating agent (what is called a hard water softening agent) in order to reduce adverse effects of mingled polyvalent metal ions, as needed.

The chelating agent may be a general-purpose hard water softening agent and related compounds thereof as a precipitation-preventing agent of calcium and magnesium, and examples thereof include nitrilotriacetic acid, diethylenetriamine pentaacetic acid, ethylenediamine tetraacetic acid, N,N,N-trimethylene phosphoric acid, ethylenediamine-N,N,N',N'-tetramethylene sulfonic acid, trans-cyclohexanediamine tetraacetic acid, 1,2-diaminopropane tetraacetic acid, glycoletherdiamine tetraacetic acid, ethylenediamine orthohydroxyphenyl acetic acid, ethylenediamine disuccinic acid (SS-isomer), N-(2-carboxylate ethyl)-L-aspartic acid, β-alanine diacetic acid, 2-phosphonobutane-1,2,4-tricarboxylic acid, 1-hydroxyethylidene-1,1-diphosphonic acid, N,N'-bis(2-hydroxybenzyl)ethylenediamine-N,N'-diacetic acid and 1,2-dihydroxybenzene-4,6-disulfonic acid.

A plurality of chelating agents may be used together, if necessary.

The addition amount of the chelating agent may be an amount enough for blocking metal ions such as mingled polyvalent metal ions. For example, the chelating agent is added in an amount of from 0.0003 mol to 0.07 mol in 1 L of the polishing liquid to be directly used for polishing.

Among the components added for preparing a concentrated liquid of the polishing liquid, the blending amount of the component having a solubility of 5% or less in water at room temperature is preferably at most 2 times, and more preferably at most 1.5 times the solubility in water at room temperature in order to prevent the component from precipitating when the concentrated liquid is cooled to 5°C.

The polishing liquid of the invention is suitable for polishing the barrier metal layer that is provided for preventing diffusion of copper and interposed between the wiring line composed of metallic copper and/or copper alloy and an interlayer insulation film.

### [Barrier metal material]

As the material constituting a barrier metal layer that is an object of polishing of the polishing liquid according to the invention is generally a metal material of low resistivity, and particularly TiN, TiW, Ta, TaN, W, or WN is preferable, and among all Ta and TaN are particularly preferable.

### [Material for wiring metal]

A work to be polished that is an object of polishing in the invention preferably has wirings comprising a copper metal and/or copper alloy, for example, applied to semiconductor devices such as LSIs. Particularly, as the material for the wiring, copper alloys are preferable. Further, among the copper alloys, copper alloys containing silver are preferable.

The silver content in the copper alloy is preferably 40 mass% or less, particularly preferably 10 mass% or less, and further preferably 1 mass% or less, and a most excellent effect is obtained in copper alloys containing silver within a range from 0.00001 to 0.1 mass%.

### [Size of wiring]

In the present invention, in a case where the work to be polished that is an object of polishing is applied, for example, to DRAM devices, it preferably has a wiring with a half-pitch of 0.15 µm or less, more preferably, 0.10 µm or less, and further preferably 0.08 µm or less.

On the other hand, in a case where the work to be polished is applied, for example, to MPU type devices, it preferably has a wiring with 0.12 µm or less, more preferably 0.09 µm or less, and further preferably 0.07 µm or less.

The polishing liquid in the invention provides a particularly excellent effect to the work to be polished that has such wirings.

### [Polishing method]

Embodiments of the polishing liquid of the invention include:
(1) a case where the polishing liquid is a concentrated liquid which is diluted before use with water or an aqueous solution to form a liquid to be directly used;
(2) a case where respective components are prepared in the form of an aqueous solution as described below, and they are mixed and optionally diluted with water to form a liquid to be directly used; and
(3) a case where the polishing liquid is a liquid to be directly used.

The polishing liquid in any of the cases is applicable to the polishing method using the polishing liquid of the invention.

The polishing method is a method of supplying a polishing liquid to a polishing pad on a polishing platen, bringing the pad into contact with a surface of a work to be polished and moving the surface to be polished and the polishing pad relatively.

As an apparatus used for polishing, general polishing apparatus having a holder for holding a work to be polished that has a surface to be polished (for example, a wafer provided with a conductive material film) and a polishing platen to which a polishing pad is attached (and which is provided with a motor capable of changing the number of rotation, etc.). As the polishing pad, general non-woven fabrics, foamed polyurethanes, porous fluoro resins, etc. can be used with no particular restriction. Further, while the polishing condition is not limited, the rotational speed of the polishing platen is preferably a low rotational speed of 200 rpm or less so that the work to be polished does not pop out. The pressure of a work to be polished that has a surface to be polished (film to be polished) onto the polishing pad is preferably from 0.68 to 34.5 KPa, and more preferably from 3.40 to 20.7 KPa in order to satisfy the in-plane uniformity of the polishing speed on the surface to be polished and the planarity of the patterns.

During polishing, the polishing liquid is continuously supplied by a pump or the like to the polishing pad.

The work to be polished after completion of polishing is cleaned thoroughly in a running water and then dried after spinning off water droplets on the work to be polished by using a spin drier or the like.

In the invention, in a case of diluting the concentrated liquid as in the above described (1), an aqueous solution as shown below can be used. The aqueous solution is a water containing at least one of oxidizing agents, organic acids, additives, and surfactants, and the sum of the components contained in the aqueous solution and the components contained in the concentrated liquid to be diluted are components of the polishing liquid to be directly used for polishing.

In a case of using a concentrated liquid to be diluted with an aqueous solution as described above, since less soluble components can be added in the form of an aqueous solution afterward, a highly concentrated liquid can be prepared.

Further, the method of diluting a concentrated liquid with water or an aqueous solution may be a method of joining a pipeline for supplying the concentrated polishing liquid and a pipeline for supplying water or the aqueous solution in the midway to mix these liquids, and supplying the resulting mixed and diluted liquid to the polishing pad. For mixing the concentrated liquid and water or the aqueous solution, methods usually adopted can be used, for example, a method of passing these liquids through a narrow channel in a state of applying a pressure to collide and mix them to each other, a method of packing fillers such as glass tubes in the pipeline and repeating joining and separating of liquid flows, or a method of providing vanes rotated by a power in the pipeline.

The supplying speed of the polishing liquid is preferably from 10 to 1,000 mL/min, and more preferably from 170 to 800 mL/min in order to satisfy the in-plane uniformity of the polishing speed on the surface to be polished and planarity of the pattern.

Further, the method of polishing while diluting the concentrated liquid with water or an aqueous solution may be a method of separately disposing a pipeline for supplying a polishing liquid and a pipeline for supplying water or an aqueous solution, supplying a predetermined amount of liquid from each of the pipelines to the polishing pad, and conducting polishing while mixing these liquids by a relative movement of the polishing pad and the surface to be polished. Further, a method of placing and mixing a concentrated liquid and water or an aqueous solution in a predetermined amount in one vessel, then supplying the mixed polishing liquid to the polishing pad and conducting polishing can also be used.

Further, another polishing method may be a method of dividing components to be contained in the polishing liquid into at least two constituent components, diluting them with water or an aqueous solution when using them, supplying them to a polishing pad on a polishing platen, bringing the pad into contact with the surface to be polished and conducting polishing by moving the surface to be polished and the polishing pad relatively.

For example, a constituent component (A) is an oxidizing agent and a constituent component (B) is an organic acid, additive, surfactant and water, and the constituent component (A) and the constituent component (B) are used after being diluted with water or an aqueous solution.

Further, for example, additives of low solubility are divided into two constituent components (A) and (B), for example, a constituent component (A) is an oxidizing agent, additive and surfactant and a constituent component (B) is an organic acid, additive, surfactant and water, and the constituent component (A) and the constituent component (B) are used after being diluted with water or an aqueous solution. In these cases, the specific colloidal silica (polishing particles) in the invention are preferably contained in the constituent component (A).

In the case of embodiments as described above, three pipelines for supplying the constituent component (A), the constituent component (B), and water or the aqueous solution respectively are necessary, and dilution and mixing may be conducted by a method of joining the three pipelines to one pipeline for supplying to the polishing pad and conducting mixing in the pipeline. In this case, it is also possible to join two pipelines and then join the other pipeline thereto. Specifically, there is a method of mixing a constituent component containing a less soluble additive with the other constituent component and ensuring a dissolution time by making the mixing channel longer and then joining a pipeline for water or an aqueous solution thereto.

Another mixing method may be a method of introducing three pipelines directly to the polishing pad respectively and mixing the liquids by relative movement between the polishing pad and the surface to be polished, or a method of mixing three constituent components in one vessel and then supplying the resulting diluted polishing liquid therefrom to the polishing pad.

In polishing methods as described above, for example, one of the constituent components that contains an oxidizing agent is kept at 40°C or lower, and the other constituent components are heated to a temperature within a range from a room temperature to 100°C, so that when mixing one constituent component with the other constituent components or when diluting with water or an aqueous solution, the liquid temperature becomes 40°C or lower. This method is a preferable method of increasing the solubility of a material for the polishing liquid that has a lower solubility by utilizing the phenomenon that the solubility increases as the temperature is higher.

Since the material which is dissolved by heating the other constituent components within a temperature range from room temperature to 100°C is precipitated in the solution when the temperature lowers, in a case of using the other constituent components in a low temperature state, it is necessary to heat the liquids in advance to dissolve the precipitated material. For this purpose, means for heating and delivering the other constituent components in which the material is dissolved, and means for stirring the liquid containing precipitates, delivering the liquid and heating the pipeline to dissolve the precipitates can be adopted. Since the oxidizing agent may be decomposed when the temperature of one constituent component containing the oxidizing agent is elevated to 40°C or higher by the heated other constituent components, it is preferable that the temperature is 40°C or lower in a case of mixing the other heated constituent components and the one constituent component containing the oxidizing agent.

As described above, in this invention, the components for the polishing liquid may be divided into two or more portions and supplied to the surface to be polished. In this case, preferably, the components are divided into a component containing an oxidizing agent and a component containing an organic acid, and then separately supplied. Further, the polishing liquid may be used as a concentrated liquid and a dilution water may be separately supplied to the surface to be polished.

In the invention, in a case of applying the method of dividing the components of the polishing liquid into two or more portions and supplying them to the surface to be polished, the amount of supply represents the total of the supply amounts from the respective pipelines.

### [Pad]

The polishing pad that can be used in the polishing method in the invention may be a non-foam pad or a foam pad. A rigid bulk material of a synthetic resin such as a plastic plate may be used for the pad in the former case. In the latter case, an independent foam product (dry foam product), a continuous foam product (wet foam product) and a two-layer composite product (laminated product) may be used, and a two-layer composite product (laminated product) is preferable. Foaming may be uniform or non-uniform.

The polishing pad may contain polishing particles (such as ceria, silica, alumina and resin) used for polishing. While either soft type or hard type polishing particles are available, any of them may be used. Particles having different hardness are preferably used in respective layers of the laminated polishing pad. A non-woven fabric, artificial leather, polyamide, polyurethane, polyester and polycarbonate are preferable materials of the polishing pad. Lattice grooves, pits, concentric grooves or spiral grooves may be formed on the surface of the pad to be in contact with the polishing surface.

### [Wafer]

The wafer on which CMP is performed with the polishing liquid of the invention preferably has a diameter of 200 mm or more, particularly 300 mm or more. The invention is highly effective for a wafer having a diameter of 300 mm or more.

### (Polishing apparatus)

While the apparatuses applicable to polishing using the polishing liquid of the invention are not particularly restricted, examples thereof include Mirra Mesa CMP and Reflexion CMP (trade names, manufactured by Applied Materials Inc.), FREX 200 and FREX 300 (trade names, manufactured by Ebara Corp.), NPS 3301 and NPS 2301 (trade names, manufactured by Nikon Corp.), A-FP-310A and A-FP-210A (trade names, manufactured by Tokyo Seimitsu Co., Ltd.), 2300 TERES (trade name, manufactured by Lam Research Co., Ltd.), and Momentum (trade name, manufactured by Speedfam IPEC).

### EXAMPLES

The present invention is to be described more specifically by way of examples but the invention is not restricted to them.

### <Examples 1 to 20, Comparative Example 1>

Polishing liquids S-1 to S-21 containing the components shown in the following Table 1 were prepared.

In the polishing liquids S-1 to S-21, pure water was added to the components described in Table 1 such that the entire amount was 1,000 mL. A pH value was adjusted with aqueous ammonia and nitric acid.

### (Colloidal silica used in Examples)

Specific colloidal silicas (A-1) and (A-2) were prepared as described below. They are colloidal silicas covered at a portion of the surface thereof with aluminum.

In each of the specific colloidal silicas (A-1) and (A-2), number of introduced aluminum atoms/number of surface silicon atom sites = 1%. Further, primary particle diameter (volume equivalent diameter) of the specific colloidal silica was 45 nm when measured by the method described above.

Further, as another colloidal silica, a colloidal silica which was not the specific colloids silica, that is, a colloidal silica in which the surface silicon atoms were not substituted with aluminum atoms (PL3: manufactured by Fuso Chemical Industry Co., volume average particle diameter of 40 nm) was used. In Table 1, this colloidal silica is indicated as non-specific colloidal silica.

### (Preparation of specific colloidal silica)

Aqueous ammonia was added to 1,000 g of 20 mass% aqueous dispersion of a colloidal silica of a size (volume equivalent diameter) of 40 nm to control pH to 9.0 and, subsequently, while stirring at a room temperature, 15.9 g of an aqueous solution of sodium aluminate with an Al₂O₃ concentration of 3.6 mass% and an Na₂O/Al₂O₃ molar ratio of 1.50 was slowly added thereto within several minutes and stirred for 0.5 hours.

When preparing the specific colloidal silica (A-1), the sol obtained by the method described above was placed in an autoclave device made of SUS, heated at 130°C for 4 hrs and then passed through a column filled with a hydrogen type strongly acidic cation exchange resin (Amberlite IR-120B) and a column filled with a hydroxyl type strongly basic anion exchange resin (Amberlite IRA-410) at a space velocity of 1 h⁻¹ at room temperature, and an initial fraction was cut.

When preparing the specific colloidal silica (A-2), the sol obtained by the method described above was passed without heating through a column filled with a hydrogen type strongly acidic cation exchange resin (Amberlite IR-120B) and a column filled with a hydroxyl type strongly basic anion exchange resin (Amberlite IRA-410) at a space velocity of 1 h⁻¹ at a room temperature and the initial fraction was cut.

The surface atom substitution ratio of the thus obtained specific colloidal silicas (A-1) and (A-2) (number of introduced aluminum atoms/number of surface silicon atom sites) was determined as described below.

At first, among sodium aluminate added to the dispersion liquid, the amount of sodium aluminate consumed was calculated based on the umreacted sodium aluminate remaining after reaction. Assuming that 100% of the consumed sodium aluminate was reacted, the surface atom substitution ratio was estimated based on the surface area converted from the colloidal silica diameter, the specific gravity 2.2 of the colloidal silica, and the number of silanol groups per unit surface area (5 to 8 /nm²).

### [Evaluation]

Using an apparatus "LGP-612" manufactured by Lapmaster SFF Corp. as a polishing apparatus, a metal film formed on a wafer was polished while supplying the slurry described above under the following conditions.

### (Polishing conditions)

Wafer: 8 inch silicon pattern wafer with copper film
Rotation number of the table: 64 rpm
Rotation number of the head: 65 rpm (processing line speed = 1.0 m/s)
Polishing pressure: 140 hPa
Polishing pad: No.: IC-1400, manufactured by Rohm and Haas Co. (K-grp) + (A-21)
Slurry supply speed: 200 ml/min

### (Evaluation of erosion)

Evaluation was carried out with a polished wafer obtained by polishing the pattern wafer for a time such that copper in the non-wiring portion was completely polished, and additionally for a time corresponding to 50% of the above described time (erosion after polishing was 30 nm in line 9 µm/space 1 µm). Using the wafer, erosion of the wafer polished for 30 sec with each polishing liquid (line 9 µm/space 1 µm) was measured by a scanning electron microscope S4800 (manufactured by Hitachi High Techlonogies Corp.).

### (Evaluation for scratch)

After cleaning and drying the wafer polished as described above, the wafer was observed with naked eyes and by an optical microscope to measure the number of scratches on the entire surface of the wafer.

**Table 1**

| | Polishing liquid | Oxidizing agent (content) | Polishing particles (content) | Other components (content) | pH | Erosion (nm) | Scratch (number/ wafer) |
|---|---|---|---|---|---|---|---|
| Ex. 1 | S-1 | Hydrogen peroxide (1 mass%) | A-1 (10 mass%) | Malic acid (10 g/L) | 2.5 | 35 | 2 |
| | | | | BTA (1 g/L) | | | |
| Ex. 2 | S-2 | Hydrogen peroxide (1 mass%) | A-1 (10 mass%) | Lactic acid (10 g/L) | 2.5 | 40 | 3 |
| | | | | BTA (1 g/L) | | | |
| Ex. 3 | S-3 | Hydrogen peroxide (0.8 mass%) | A-1 (12 mass%) | Lactic acid (10 g/L) | 2.5 | 25 | 1 |
| | | | | DBTA (0.5 g/L) | | | |
| Ex. 4 | S-4 | Hydrogen peroxide (1 mass%) | A-1 (10 mass%) | Glycolic acid (10 g/L) | 2.5 | 30 | 0 |
| | | | | BTA (1 g/L) | | | |
| Ex. 5 | S-5 | Hydrogen peroxide (0.5 mass%) | A-1 (10 mass%) | Glycolic acid (10 g/L) | 2.5 | 55 | 0 |
| | | | | DCEBTA (1.5 g/L) | | | |
| Ex. 6 | S-6 | Hydrogen peroxide (1 mass%) | A-1 (10 mass%) | Lactic acid (10 g/L) | 2.5 | 35 | 2 |
| | | | | HEABTA (1.5 g/L) | | | |
| Ex. 7 | S-7 | Hydrogen peroxide (1 mass%) | A-1 (5 mass%) | Tartaric acid (10 g/L) BTA (1 g/L) | 2.5 | 30 | 5 |
| | | | | | | | |
| Ex. 8 | S-8 | Hydrogen peroxide (1 mass%) | A-1 (5 mass%) | Lactic acid (10 g/L) | 2.0 | 40 | 1 |
| | | | | BTA (1 g/L) | | | |
| | | | | Dodecyl benzene sulfonic acid (0.03 g/L) | | | |
| Ex. 9 | S-9 | Hydrogen peroxide (1 mass%) | A-1 (10 mass%) | Maleic acid (10g/L) | 2.0 | 35 | 2 |
| | | | | DBTA (1 g/L) | | | |
| | | | | Triethyl ammonium (1g/L) | | | |
| Ex. 10 | S-10 | Hydrogen peroxide (1 mass%) | A-1 (5 mass%) | Tartaric acid (10 g/L) | 2.0 | 45 | 4 |
| | | | | HMBTA (1.5 g/L) | | | |
| Ex. 11 | S-11 | Hydrogen peroxide (1 mass%) | A-2 (10 mass%) | Malic acid (10g/L) | 3.0 | 60 | 0 |
| | | | | DCEBTA (1.5 g/L) | | | |
| | | | | Dodecyl benzene sulfonic acid (0.03 g/L ) | | | |
| Ex. 12 | S-12 | Hydrogen peroxide (0.5 mass%) | A-2 (10 mass%) | Glycolic acid (10 g/L) | 3.0 | 35 | 3 |
| | | | | DBTA (1.5 g/L) | | | |
| Ex. 13 | S-13 | Hydrogen peroxide (1 mass%) | A-2 (10 mass%) | Malic acid (10 g/L) | 3.0 | 30 | 1 |
| | | | | HEABTA (1.5 g/L) | | | |
| Ex. 14 | S-14 | Hydrogen peroxide (1 mass%) | A-2 (10 mass%) | Tartaric acid (10 g/L) | 2.0 | 25 | 2 |
| | | | | HEABTA (1.5 g/L) | | | |
| Ex. 15 | S-15 | Hydrogen peroxide (1 mass%) | A-2 (10 mass%) | Lactic acid (10 g/L) | 2.0 | 35 | 0 |
| | | | | HMBTA (1.5 g/L) | | | |
| | | | | Dodecyl benzene sulfonic acid (0.3 g/L) | | | |
| Ex. 16 | S-16 | Hydrogen peroxide (1 mass%) | A-2 (10 mass%) | Malic acid (10 g/L) | 2.5 | 45 | 3 |
| | | | | DBTA (1 g/L) | | | |
| Ex. 17 | S-17 | Hydrogen peroxide (1 mass%) | A-2 (10 mass%) | Glycolic acid (10 g/L) | 2.5 | 30 | 4 |
| | | | | BTA (1 g/L) | | | |
| | | | | Triethyl ammonium (1g/L) | | | |
| | | | | Dodecyl benzene sulfonic acid (0.03 g/L) | | | |
| Ex. 18 | S-18 | Hydrogen peroxide (1 mass%) | A-2 (5 mass%) | Lactic acid (10 g/L) | 2.5 | 50 | 0 |
| | | | | DCEBTA (1.5 g/L) | | | |
| | | | | Ammonium Laurate(0.02 g/L) | | | |
| Ex. 19 | S-19 | Hydrogen peroxide (0.5 mass%) | A-2 (12 mass%) | Maleic acid (10 g/L) | 2.5 | 35 | 1 |
| | | | | HMBTA (1.5 g/L) | | | |
| Ex. 20 | S-20 | Hydrogen peroxide (1 mass%) | A-2 (12 mass%) | Glycolic acid (10 g/L) | 2.5 | 40 | 2 |
| | | | | DCEBTA(1.5g/L) | | | |
| | | | | Dodecyl benzene sulfonic acid (0.03 g/L) | | | |
| Comp. Ex. 1 | S-21 | Hydrogen peroxide (1 mass%) | Non-specific colloidal silica | Glycine (8 g/L) | 2.5 | 120 | 8 |
| | | | | BTA (1.0 g/L) | | | |

Compounds abbreviated as BTA, DBTA, DCEBTA, HEABTA, and HMBTA in the table are shown below.
BTA: 1,2,3-benzotriazole
DBTA: 5,6-dimethyl-1,2,3-benzotriazole
DCEBTA: 1-(1,2-dicarboxyethyl)benzotriazole
HEABTA: 1-[N,N-bis(hydroxytethyl)aminomethyl]benzotriazole
HMBTA: 1-(hydroxymethyl)benzotriazole

According to Table 1, it can be seen that the polishing liquids of Examples 1 to 20 containing an oxidizing agent and the specific colloidal silica showed low erosion and few scratches as compared with Comparative Example 1.

The present invention provides at least the following embodiments 1 to 10.
1. A polishing liquid for polishing a barrier layer of a semiconductor integrated circuit, the polishing liquid comprising colloidal silica covered at a portion of a surface thereof with aluminum, and an oxidizing agent, wherein the polishing liquid has a pH of from 2 to 7.
2. The polishing liquid according to embodiment 1, wherein the primary particle diameter of the colloidal silica is from 10 to 60 nm.
3. The polishing liquid according to embodiment 1, wherein the concentration of the colloidal silica is from 1 to 15 mass% based on the mass of the polishing liquid.
4. The polishing liquid according to embodiment 1, further comprising a quaternary alkyl ammonium compound.
5. The polishing liquid according to embodiment 1, further comprising an anionic surfactant.
6. The polishing liquid according to embodiment 1, further comprising an organic acid having a carboxyl group.
7. The polishing liquid according to embodiment 6, wherein the organic acid is a compound represented by the following formula (1):

   **R**-COOH (1)

   wherein R represents a hydrogen atom, a carboxyl group, or a hydrocarbon group, and the hydrocarbon group may further be substituted with a hydroxyl group, a carboxyl group, or a hydrocarbon group.
8. The polishing liquid according to embodiment 1, further comprising a heteroaromatic ring compound that contains three or more nitrogen atoms in the molecule and has a condensed ring structure.
9. The polishing liquid according to embodiment 8, wherein the heteroaromatic ring compound is benzotriazole or a derivative thereof.
10. The polishing liquid according to embodiment 8, wherein the concentration of the heteroaromatic ring compound is 0.2 mass% or less based on the mass of the polishing liquid.

Therefore, according to the invention, suppression of erosion and suppression of scratches can be achieved at the same time in a polishing liquid for a barrier layer that includes solid polishing particles.

## Claims

1. A polishing liquid for polishing a barrier layer of a semiconductor integrated circuit, the polishing liquid comprising colloidal silica covered at a portion of a surface thereof with aluminum, and an oxidizing agent, wherein the polishing liquid has a pH of from 2 to 7.

2. The polishing liquid according to claim 1, wherein the primary particle diameter of the colloidal silica is from 10 to 60 nm.

3. The polishing liquid according to claim 1, wherein the concentration of the colloidal silica is from 1 to 15 mass% based on the mass of the polishing liquid.

4. The polishing liquid according to claim 1, further comprising a quaternary alkyl ammonium compound.

5. The polishing liquid according to claim 1, further comprising an anionic surfactant.

6. The polishing liquid according to claim 1, further comprising an organic acid having a carboxyl group.

7. The polishing liquid according to claim 6, wherein the organic acid is a compound represented by the following formula (1):
R-COOH (1)
wherein R represents a hydrogen atom, a carboxyl group, or a hydrocarbon group, and the hydrocarbon group may further be substituted with a hydroxyl group, a carboxyl group, or a hydrocarbon group.

8. The polishing liquid according to claim 1, further comprising a heteroaromatic ring compound that contains three or more nitrogen atoms in the molecule and has a condensed ring structure.

9. The polishing liquid according to claim 8, wherein the heteroaromatic ring compound is benzotriazole or a derivative thereof.

10. The polishing liquid according to claim 8, wherein the concentration of the heteroaromatic ring compound is 0.2 mass% or less based on the mass of the polishing liquid.
